Europäisches Patentamt

European Patent Office

Office européen des brevets

(11) Publication number: **0 388 214**
**A1**

# EUROPEAN PATENT APPLICATION

(21) Application number: 90302819.9

(22) Date of filing: 15.03.90

(51) Int. Cl.5: **C04B 35/00, C04B 35/58, H01L 39/24**

(30) Priority: 17.03.89 US 324936

(43) Date of publication of application:
19.09.90 Bulletin 90/38

(84) Designated Contracting States:
AT BE CH DE FR GB IT LI NL SE

(71) Applicant: THE DOW CHEMICAL COMPANY
2030 Dow Center Abbott Road
Midland, MI 48640(US)

(72) Inventor: Dichiara, Robert A.
2310 8th Street
Charlestown, Massachusetts 02129(US)
Inventor: Khoury, Issam A.
1213 Evamar Drive
Midland, Michigan 48640(US)

(74) Representative: Raynor, John et al
W.H. Beck, Greener & Co 7 Stone Buildings
Lincoln's Inn
London WC2A 3SZ(GB)

(54) Ceramic greenware formulation for dry pressed greenware.

(57) A ceramic greenware formulation is described including (a) a ceramic or cermet material; (b) a binder of poly(ethyloxazoline) and polyethylene glycol, such that the ratio of polyethylene glycol to poly(ethyloxazoline) is 1 to 3; and (c) a solvent. This slip formulation can be prepared by admixing the selected ceramic-containing material, the binder and solvent to form a slip, which can then be dried to form a ceramic greenware powder. The powder can then be pressed to form a ceramic greenware article.

EP 0 388 214 A1

## CERAMIC GREENWARE FORMULATION FOR DRY PRESSED GREENWARE

This invention relates to ceramic greenware. More particularly, it relates to a composition and method of preparing greenware.

Conventional ceramic processing typically comprises ball milling a slurry, or slip, which contains a ceramic material and a solvent, to reduce the particle size of the ceramic material. The milled slurry is dried, by a means such as spray drying or pan drying, and the dried ceramic composition is then formed into greenware.

In the fabrication of ceramic articles, a temporary binder is typically employed. A good binder should satisfy several criteria. It should be soluble in the slurry containing the ceramic, and it should have a low solution viscosity, thereby facilitating ball milling and permitting high solids content in the slurry. It should be compatible with other additives and processing steps. Since the binder is generally not a desirable component of the final ceramic article, it should be easily removable at some point in the processing sequence. The binder should also impart green strength to the green fabricated article.

A number of binders have been developed that possess some or all of these desirable characteristics. Among these are the polyethylene glycols. U.S. Patent No. 3,003,885 illustrates the use of a polyethylene oxide wax having a molecular weight of 400,000 to prepare a titanium diboride article. Another patent describing the use of polyethylene glycol is U.S. Patent No. 3,285,873, which shows the use of polyethylene glycol and one or more polyolefins as binders in a variety of ceramic compositions such as those containing alumina, clay, quartz, steatite or talc. U.S. Patent No. 3,720,740 discloses the use of polyethylene glycol in preparing cold pressed molded articles using boron nitride.

U.S. Patent No. 3,796,564 shows the use of polyethylene glycol to produce hard ceramic bodies of boron carbide, silicon carbide and silicon. U.S. Patent No. 4,197,118 shows the use of polyethylene glycol to produce greenware bodies of alumina. U.S. Patent No. 4,233,077 describes using polyethylene oxide to produce extruded greenware bodies of refractory hard metal powders such as silicon carbide and titanium diboride. U.S. Patent No. 4,233,256 describes using polyethylene glycol with thermoplastics to produce injection molding sinterable carbide ceramic materials. U.S. Patent No. 4,724,121 describes using polyethylene glycol in a binder system for nickel oxide and other non-carbide ceramics.

Many different solvents have been used for the preparation of ceramic greenware. The solvents are used to prepare the ceramic slip, which may then be milled to enhance mixing and/or for size reduction purposes. The viscosity of the slip obviously has an impact on the success of the drying method, such as spray drying, and when large amounts of solvent must be used to reduce viscosity, the ceramic loading is comparably reduced. High viscosity of the slip results in losses of the slip in the ball mill, and may produce an unstable slip that phase-separates quickly, leading to a non-homogeneous system. Known solvents include, for example, ethanol (e.g., U.S. Patent Nos. 4,071,594 and 4,710,227); water (e.g., U.S. Patent No. 3,881,911); trichloroethylene (e.g., U.S. Patent Nos 2,929,126 and 3,277,222); and trichloroethane (e.g. U.S. Patent Nos 3,652,749 and 3,705,223).

Thus, it would be desirable to have a ceramic greenware formulation using a binder that is soluble in the slurry containing the ceramic, has a low viscosity, is potentially compatible with other additives and processing steps, can be easily removed, and imparts green strength to the green fabricated article. It is further desirable that the green fabricated article produced from the ceramic greenware formulation can be easily removed from the mold after pressing.

Accordingly, the present invention provides a ceramic greenware formulation, comprising; (a) a ceramic material; and (b) a binder consisting essentially of poly(ethyloxazoline) and polyethylene glycol, such that the ratio of polyethylene glycol to poly(ethyloxazoline) is 1 to 3. The formulation typically includes a solvent.

The present invention is also a process for preparing a ceramic greenware formulation, comprising the steps of: (a) admixing a ceramic material, a binder and a solvent to form an admixture or slip, the binder consisting essentially of poly(ethyloxazoline) and polyethylene glycol, such that the ratio of polyethylene glycol to poly(ethyloxazoline) is 1 to 3; and (b) drying the slip to form a powder.

The present invention is a ceramic greenware slip formulation which can be used to prepare dry pressed ceramic greenware articles, and a method of preparing and then drying the slip formulation. These greenware articles, because of the formulation, show many advantageous properties when compared with greenware articles prepared from many other known formulations.

In general, the ceramic greenware formulation of the present invention comprises a ceramic or ceramic-containing material, a binder and a solvent. The ceramic material is preferably a ceramic or a cermet. Any ceramic which comprises an inorganic, non-metallic material as its essential component can be employed in this invention. Preferred ceramics include, for example, oxides, nitrides, carbides, borides and mixtures thereof. It is more preferred that the ceramic be selected from the group consisting of aluminum nitride and water reactive high temperature superconducting materials, particularly those conforming to the formulas $ReBa_2Cu_3O_{7-\delta}$ wherein Re is La, Nd, Sm, Eu, Gd, Tb, Dy, Ho, Er, Tm, Yb, Lu, or Y, and $\delta$ is 0-1; $(Bi_{1-x}Pb_x)_2Sr_{2-y}Ca_{n-1-z}Cu_{n-w}O_{2n+4+\delta}$ wherein x = 0-0.5, n = 1-50, y = 0-1, z = 0-1, w = 0-1, $\delta$ is 0-1, and n is an integer from 1 to 5; and $Tl_mBa_2Ca_{n-1}Cu_nO_{2n+m+2+\delta}$ wherein m is 1 or 2, $\delta$ is 0-1, and n is an integer from 1 to 50, preferably from 1 to 10. Preferred among these are the yttrium- and lanthanum barium copper oxides including $YBa_2Cu_3O_{7-\delta}$. Preferably, the ceramic-containing material consists essentially of a ceramic and, more preferably, the ceramic-containing material consists of a ceramic.

In a preferred embodiment of this invention, the ceramic-containing material is particulate and has a particle size of 100 micrometers or less, more preferably 10 micrometers or less, and most preferably 1 micrometer or less. In another preferred embodiment fiber-containing material or other reinforcing material can be mixed with the particulate ceramic-containing material. It is believed that incorporation of fibrous ceramic material or other reinforcing material may increase the strength and fracture toughness of the ceramic body produced.

In general it is preferred that the ceramic material is at least 85 percent by weight of the ceramic material and binder combined, and it is more preferred that the ceramic material is 85 to 99 percent by weight. Most preferably it is 90 to 98 percent by weight.

The binder preferably consists essentially of poly(ethyloxazoline) and polyethylene glycol. Preferably, the binder is employed in an amount sufficient to provide the greenware with sufficient strength to retain its shape during normal handling and processing. This amount is preferably 1 to 15 percent by weight of the ceramic material and binder combined, and is more preferably 2 to 10 percent. Preferably, the binder mixture is such that the ratio of the polyethylene glycol to the poly(ethyloxazoline) is 1 to 3. More preferably, this ratio is 2.

The percentage of the binder used will depend on the surface area and particle size distribution of the ceramic material. The amount of binder on the surface will vary the handling and performance characteristics, and certain processing considerations should preferably be taken into account in deciding the amount of binder. For example, a higher percentage of binder is necessary on higher surface area powders to get equivalent green handling characteristics. Similarly, when green machining is necessary, a higher percentage of binder is used to reduce the incidence of edge pull-outs (chipping). However, for ease of binder removal and for ensuring a low percentage of ash residue after burnout, less binder is preferred. Thus, in determining the amount of total binder it is useful to balance green handling and final firing considerations.

Both poly(ethyloxazoline) and polyethylene glycol are commercially available polymers. It is well known to those familiar with poly(ethyloxazoline) that it is hydrolyzed only under severe conditions, e.g., at high temperatures in the presence of very strong acids or bases. According to the present invention, the poly-(ethyloxazoline) is preferably employed in its unhydrolyzed state. However, in the process of the present invention it is also possible to employ poly(ethyloxazoline) which has been partially hydrolyzed by methods known in the art. The poly(ethyloxazoline) preferably has a weight average molecular weight ranging from 50,000 to 500,000, and more preferably from 150,000 to 250,000.

Polyethylene glycol is preferably employed in the ratios defined above. Preferably the polyethylene glycol has a weight average molecular weight greater than 1,000, i.e., the polyethylene glycol is preferably used in its solid form rather than its liquid form, which helps to enhance its function as a binder rather than as a plasticizer. It is further preferred that the polyethylene glycol has a weight average molecular weight of 1,000 to 10,000, and more preferably 3,000 to 4,000.

The ceramic greenware powder formulations of the present invention can be prepared by a method generally comprising the steps of: (a) admixing a ceramic material, the polyethylene glycol/-poly-(ethyloxazoline) binder and a solvent to form a slip; and (b) drying the slip to form a powder. This powder can then be pressed to form a ceramic greenware article.

The first step, admixing the ceramic-containing material, binder, and solvent, is preferably performed using standard ceramic processing techniques, known to those skilled in the art. The solvent employed preferably substantially solubilizes both the poly(ethyloxazoline) and the polyethylene glycol. Preferred solvents include methanol, ethanol, trichloroethane, ethylene glycol, chloroform, methyl ethyl ketone, methyl acetate, methylene chloride, acetone, dioxane, acetonitrile, propylene carbonate, ethyl hexanol and other generally polar solvents. Of these methanol, ethanol, trichloroethane and mixtures thereof are more preferred, and an ethanol/trichloroethane mixture is most preferred.

Along with the ceramic-containing material and binder, other materials can be added to the solvent to enhance the properties of the slip. For example, a dispersant, such as DARVAN*, an ammonium polyelectrolite (*DARVAN is a trademark of R.T. Vanderbilt Co., Inc.), or menhaden fish oil can preferably be added to the slip in an amount sufficient to facilitate milling and aid in maintaining a high solids to liquid ratio.

Mixtures of dispersants can also be employed. If a dispersant is employed, it is preferably in an amount which is less than 1 weight percent, and more preferably from 0.1 to 1 weight percent based on the amount of the ceramic-containing material. Die lubricants can also be added, in an amount of the ceramic-containing material. The selections of dispersants and lubricants are well known to those skilled in the art.

The slip can contain other optional components. For example, a plasticizer can be employed in an amount sufficient to lower the glass transition temperature of the binder so that the binder can flow at low applied pressure at low temperatures. If a plasticizer is employed it is preferably employed in an amount which is 5 to 50 weight percent, and more preferably from 15 to 25 percent, based on the weight of binder. Examples of plasticizers include propylene glycol, dipropylene glycol, tripropylene glycol, glycerine and the like, and mixtures thereof.

The resulting slip preferably has a solids content of 20 to 80 weight percent, and more preferably 40 to 70 weight percent. A high solids to liquid ratio in the slip is desirable for several well-known reasons. In particular, excessive solvent may produce lower density particles and high losses of fine particles. Therefore, excess solvent is preferably removed prior to further processing.

In a preferred embodiment of this invention the slip, comprising the ceramic-containing material, the poly(ethyloxazoline), the polyethylene glycol and any desired additional components, can then be milled by conventional and well-known techniques. Milling reduces the particle size of the ceramic-containing material and distributes the poly(ethyloxazoline) and the polyethylene glycol substantially uniformly over the particles.

Once the slip has been prepared and, preferably, milled to produce a thorough intermixing of the ceramic-containing materials and the binder components, the slip can then be converted into a substantially dry powder by methods known to those skilled in the art. Any method which produces a substantially dry powder from the slip can be utilized in this invention. Preferably, this conversion is accomplished by spray drying or pan drying, with or without the application of heat. To remove agglomerates from the slip, the slip is preferably filtered prior to drying. In one preferred embodiment, the slip is converted into a dry powder in an inert atmosphere, e.g., nitrogen, in order to prevent oxidation of the ceramic-containing material. Drying of the slip results in spherical particulates that flow well, allowing for easy filling of the dies.

A preformed ceramic article, i.e., a preform or greenware can be fabricated from the ceramic greenware powder formulation by any suitable means such as, for example, by drying pressing or isostatic pressing. The ceramic greenware formulation of the present invention shows reduced dusting during the dry pressing operation. The particles has a high yield stress and, when subjected to pressure, break down and knit together, forming a rigid component. Therefore, good edge retention and part definition can be achieved. The polyethylene glycol in the binder system imparts lubricating properties and softens the binder. This helps to ensure that the articles have a high green density and that no remnant structure is left behind by the agglomerates. At the same time the poly(ethyloxazoline) stiffens the binder system and imparts hardness. This hardness is needed in the dry pressed pieces to achieve good part definition and handling properties and to reduce pressed material "springback", which results in edge chipping. The final pressed greenware preferably will have the desired shape of the final product and also sufficient density to substantially retain its shape during handling and further processing. The greenware preferably possesses greater green compressive strength than ceramic greenware prepared using an equal amount of polyethylene glycol alone, and is also easier to remove from the preform mold.

The final pressed greenware formulation can, if desired, be heated to remove or "burn out" the poly(ethyloxazoline)/polyethylene glycol binder. It is desirable to burn out the binder mixture at a temperature from 380°C to 550°C. Details as to useful burnout time, temperatures and pressures can be easily ascertained by workers skilled in the art. In general, a ramp time of from 2 to 20 hours is preferred, and from 5 to 10 hours is more preferred. A soak time of from 0 to 10 hours is preferred, and more preferred is a soak time of 1 to 3 hours. Pressures up to 100,000 psi (689.5 MPa) can be employed, but 5,000 to 20,000 psi (34.5 to 137.9 MPa) is preferred, and 10,000 to 15,000 psi (68.9 to 103.4 MPa) is more preferred.

Following binder removal, the ceramic preform can be further densified using known methods. It is preferred that the ceramic greenware article be sintered to produce the desired final ceramic product.

Specific Embodiments

The following examples are included for illustrative purposes only, and are not intended to be, nor should they be construed as being, limitative of the scope of the invention or claims. All parts and percentages are by weight unless otherwise specified.

Example 1

A binder solution is prepared by mixing a dried ethanol, 200 proof (1,250 g) with poly(ethyloxazoline) (52.5 g) and polyethylene glycol, 3,350 molecular weight (105 g). At the same time in a different container a ball mill size zero is charged with 1,1,1-trichloroethane (1,250 g), menhaden fish oil (5 g), aluminum nitride (2,000 g) and yttria (60 g). The binder solution is then admixed with the charge in the ball mill while vigorously stirring to ensure that all the polyethylene glycol maintains its suspension. Alumina balls, 1/4 inch (0.63 cm) diameter, are used as milling media, with about half the mill jar being filled with them. The slip is milled for 4 to 6 hours until homogeneous. The viscosity of the slip is about 407 centipoise.

The slip is then spray-dried using a 4-foot diameter drum spray dryer. The average particle size of the spray-dried product ranges from about 25 to about 150 micrometers. Dry pressing of the powder is done at 15 to 20,000 psi (103.4 to 137.9 MPa) and pieces 6 inches x 6 inches x 3/4 inch (15.2 x 15.2 x 1.9 cm) are pressed. The powder formability is tested by preparing 250 pieces of 1 inch x 1 inch x 0.04 inch (2.5 x 2.5 x 0.1 cm). The weight of these parts varies by less than 0.01 g. Thus, the powder exhibits sufficiently predictable flowability that it can be used for commercial production of ceramic parts using fully automated equipment.

The binder is burned out under a schedule as follows:

| Temperature ($^\circ$C) | No. of Hours |
|---|---|
| 25 - 550 | 20 |
| 550 - 550 | 10 |

Carbon and oxygen analysis shows no increase in content when compared with the starting material.

Example 2

Two solutions are prepared, one containing 61.8 g polyethylene glycol, 3,350 molecular weight, in 900 ml of methanol, and the other containing 30.9 g of poly(ethyloxazoline), 200,000 molecular weight, in 975 ml of methanol. These are allowed to develop overnight. These binder solutions are then added concurrently to 1,500 g of aluminum nitride and 45 g of yttria. The produce is put into a 1.5 gallon (3.79 L) ball mill with alumina media. The product is milled for 5 hours and the slip is poured into dishes. The viscosity of the binder is low and does not hinder milling. Milling results in the breakdown of soft agglomerates.

The solvent is removed in a vacuum oven at a pressure of 125 mm-Hg and 40$^\circ$C and the solvent is recovered in a dry ice 2-propanol trap. The mixture is periodically stirred, and when the ceramic is mostly dried and the material can be crumbled, it is screened through 18-mesh (921 micrometers) and 35-mesh (420 micrometers) sieves. The powder is further dried in a vacuum oven with no heat overnight to remove the residual solvent. The material is then rescreened through a 35 mesh (420 micrometers) sieve.

The formulation is then dry pressed at a pressure of about 15,000 psi (103.4 MPa). The final greenware product shows good green strength.

The binder is then burned out under an inert atmosphere, with combustion beginning at 173$^\circ$C and being completed at 550$^\circ$C. The burned out article is then densified by sintering at 1800$^\circ$C.

Example 3

A high temperature superconducting material, $YBa_2Cu_3O_7$, is prepared by dry ball milling of yttria, barium carbonate and copper oxide to achieve uniform mixing of the oxide before calcination. The ball mill, 0.5 gallon (1.89 L) capacity, is filled with zirconia media, 33.3 g of yttria, 119.9 g of barium carbonate and 72.5 g of copper oxide. The mill is run for 1 hour and the dry milled powder is calcined in an alumina crucible in oxygen at 875$^\circ$C for 24 hours. The calcined material is crushed using a mortar and pestle, screened through a 35-mesh (420 micrometers) sieve, and recalcined at 875$^\circ$C for 12 hours to assure homogeneous calcination. The material is again crushed using a mortar and pestle and screened through a 35-mesh (420 micrometers) sieve.

Two separate binder solutions are prepared. One solution contains 2 g of polyethylene glycol, 3,350 molecular weight, in 100 ml of methanol. The other solution contains 1 g of poly(ethyloxazoline), 200,000 molecular weight, in 100 ml of methanol. Each is dissolved with stirring. These binder solutions are added concurrently to 200 g of the superconducting ceramic-containing material in a 500 g ball mill with zirconia media. The resulting formulation is milled for 5 hours and the slip is poured into a large flat pan.

The solvent is allowed to evaporate under a laboratory hood with periodic stirring until the ceramic is mostly dry and the material can be crumbled. The ceramic material is then screened through 18-mesh (921 micrometers) and 35 mesh (420 micrometers) sieves. The powder is further dried in a vacuum oven overnight to remove the residual solvent. The material is then rescreened through a 35-mesh (420 micrometers) sieve.

The resulting powder is dry pressed uniaxially at a pressure of about 12,000 psi (82.7 MPa)

The dry pressed greenware is then burned out in air, ramping from room temperature to 425° C, and sintered.

## Claims

1. A ceramic greenware formulation, comprising:
   (a) a ceramic material;
   (b) a binder of poly(ethyloxazoline) and polyethylene glycol, such that the ratio of polyethylene glycol to poly(ethyloxazoline) is 1 to 3; and
   (c) a solvent.

2. The formulation of Claim 1 wherein the ceramic material constitutes at least 85 weight percent based on the combined weight of the ceramic material and and binder.

3. The Formulation of Claim 1 or Claim 2 wherein the ceramic is aluminum nitride or a water reactive superconducting material.

4. The formulation of Claim 3 wherein the water reactive superconducting material is of the formula $ReBa_2Cu_3O_{7-\delta}$ wherein Re is La, Nd, Sm, Eu, Gd, Tb, Dy, Ho, Er, Tm, Yb, Lu, or Y, and $\delta$ is 0-1; $(Bi_{1-x}Pb_x)_2Sr_{2-y}Ca_{n-1-z}Cu_{n-w}O_{2n+4+\delta}$ wherein $X = 0$-$0.5$, $n = 1$-$50$, $y = 0$-$1$, $z = 0$-$1$, w-0-1, $\delta$ is 0-1, and n is an integer from 1 to 5; or $Tl_mBa_2Ca_{n-1}Cu_nO_{2n+m+2+\delta}$ wherein m is 1 or 2, $\delta$ is 0-1, and n is an integer from 1 to 50.

5. The formulation of Claim 4 wherein the ceramic is of the formula $ReBa_2Cu_3O_{7-\delta}$ wherein Re is La or Y and $\delta$ is 0-1.

6. The formulation of any one of the preceding Claims wherein the polyethylene glycol has a molecular weight greater than 1,000.

7. The composition of any one of the preceding Claims wherein the poly(ethyloxazoline) has a molecular weight of 50,000 to 500,000.

8. The formulation of any one of the preceding Claims wherein the solvent is methanol, ethanol, trichloroethane, ethylene glycol, chloroform, methyl ethyl ketone, methyl acetate, methylene chloride, acetone, dioxane, acetonitrile, propylene carbonate, ethyl hexanol or a mixture of two or more thereof.

9. A process for preparing a ceramic greenware formulation, comprising:
   (a) admixing a ceramic material, a binder, and a solvent wherein the binder is poly(ethyloxazoline) and polyethylene glycol, such that the ratio of polyethylene glycol to poly(ethyloxazoline) is from 1 to 3; and
   (b) drying said admixture to form a powder.

10. The process of Claim 9 wherein the ceramic material constitutes from 85 to 99 weight percent, based on the combination of the cermaic material and binder.

11. The process of Claim 10 wherein the ceramic is aluminum nitride or a water reactive superconducting material of the formula $ReBa_2Cu_3O_{7-\delta}$ wherein Re is La, Nd, Sm, Eu, Gd, Tb, Dy, Ho, Er, Tm, Yb, Lu, or Y, and $\delta$ is 0-1; $(Bi_{1-x}Pb_x)_2Sr_{2-y}Ca_{n-1-z}Cu_{n-w}O_{2n+4+\delta}$ wherein $x = 0$-$0.5$, $n = 1$-$50$, $y = 0$-$1$, $z = 0$-$1$, $w = 0$-$1$, $\delta$ is 0-1, and n is an integer 1 to 5; or $Tl_mBa_2Ca_{n-1}Cu_nO_{2n+m+2+\delta}$ wherein m is 1 or 2, $\delta$ is 0-1, and n is an integer from 1 to 50.

12. The process of any one of Claims 9 to 11 wherein the drying is done by spray drying.

13. The process of any one of Claims 9 to 12 including the further step of pressing the powder to form a ceramic greenware article.

14. The process of Claim 13 wherein the pressing is done by dry pressing.

15. A ceramic article produced by firing a composition as claimed in any one of Claims 1 to 8.

6

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | EP-A-0 244 940 (THE DOW CHEMICAL CO.) * Claims 1-3,5-7,9 * | 1-3,7-15 | C 04 B 35/00<br>C 04 B 35/58<br>H 01 L 39/24 |
| A | EP-A-0 292 125 (FUJITSU LTD) * Claims 1,14; page 5, lines 40-48 * | 1,3-5,9,11 | |
| A | EP-A-0 276 149 (KERAMONT ADVANCED CERAMIC PRODUCTS CORP.) * Claims 1,14,15; column 3, lines 39-60 * | 1-3,6-11 | |

TECHNICAL FIELDS SEARCHED (Int. Cl.5)

C 04 B
H 01 L

The present search report has been drawn up for all claims

| Place of search | Date of completion of the search | Examiner |
|---|---|---|
| THE HAGUE | 15-06-1990 | LUETHE H. |